# EUROPEAN PATENT SPECIFICATION

(11) **EP 0 589 124 B1**
(45) Date of publication and mention of the grant of the patent: **07.01.1999**
(21) Application number: 92830514.3
(22) Date of filing: 23.09.1992
(51) Int. Cl.: H01L 21/32, H01L 21/76

(54) **Method for eliminating the bird's beak from selective oxidations of semiconductor electronic devices**
Verfahren zum Verhindern des "Bird's beak" während der selektiven Oxidation von elektronischen Halbleiteranordnungen
Procédé pour éliminer le "bird's beak" dans les oxydations sélectives des dispositifs semi-conducteurs électroniques

(43) Date of publication of application: 30.03.1994
(73) Proprietor: CO.RI.M.ME., I-95121 Catania (IT)
(72) Inventor: Rapisarda, Cirino, I-95032 Belpasso (CT) (IT)
(74) Representative: Botti, Mario

(56) References cited:
- EP-A- 0 052 948
- NL-A- 8 601 415
- IBM TECHNICAL DISCLOSURE BULLETIN. vol. 24, no. 9, February 1982, NEW YORK US pages 4744 - 4745 C.G. JAMBOTKAR. 'METHOD FOR FORMING RECCESSED OXIDE ISOLATION ISLANDS.'

## Description

This invention relates to a method for eliminating the bird's beak from selective oxidations of semiconductor electronic devices.

More particularly, the invention relates to a method applied to semiconductor devices having a semiconductor substrate covered by an oxide layer which is covered, in turn, by a first layer of nitride, and wherein at least one pit is opened for growing an isolation region therein.

As it is well known, a silicon local oxidation technology known as LOCOS has been extensively employed to provide isolation regions between semiconductor devices or elements of one device, e.g. to create field oxide regions.

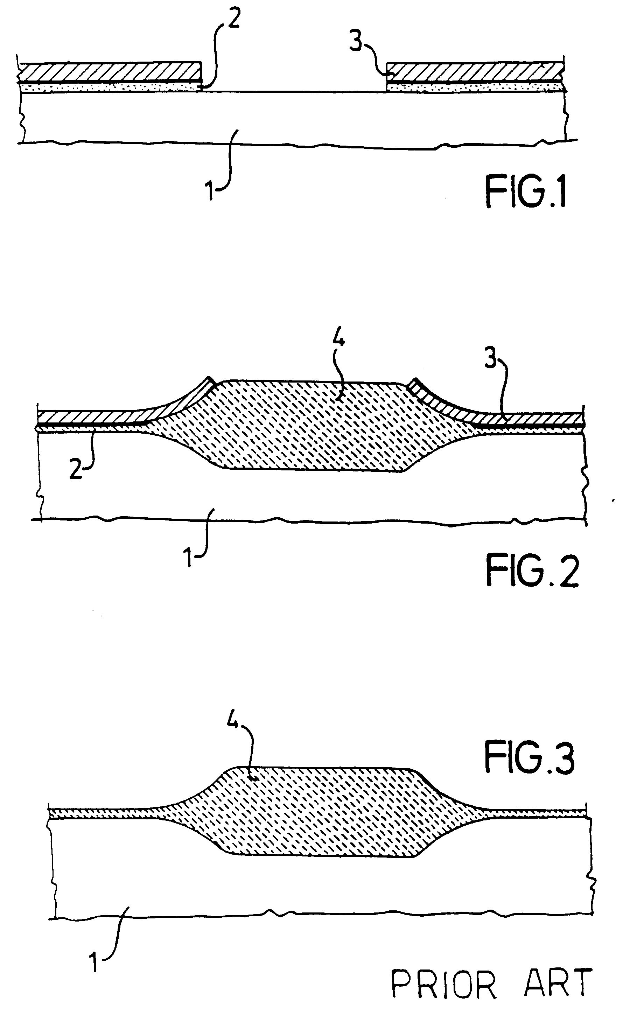

A typical sequence of the operations involved in a LOCOS technique is shown in Figures 1, 2 and 3 of the accompanying drawings.

An oxide layer 2 is grown over a substrate 1 of semiconductor silicon. The oxide 2 is then covered with a nitride layer 3, and a subsequent phototechnique step results in the active areas of the device being defined.

By a diffusion process, the silicon oxide is grown to the configuration shown in Figure 2. Subsequent removal of the nitride yields the structure shown in Figure 3.

The above-outlined LOCOS technology invariably leaves a so-called bird's beak whose length is approximately 85% of the grown oxide thickness.

This reflects in a loss of active area available for making the device.

Thus, the design effort devoted to lessening the size of the device, that is the occupied semiconductor area, is almost entirely frustrated by the intruding presence of the bird's beak.

To obviate this serious drawback, the prior art has suggested in recent years a number of expedients directed to reducing the size of the bird's beak.

It is well recognized, for instance, that a reduction in length of the beak would also depend on the capability of the nitride to seal the silicon surface and prevent oxygen from diffusing across the nitride/silicon oxide interface.

Reference can be had on the subject to an article "Sealed-interface local oxidation technology", IEEE Trans. Electron Devices, vol. ED-29, pages 644-561, April 1982.

In order to reduce the size of the beak, one might think of subjecting the silicon surface to a nitriding process, but such an approach would not be practicable because it introduces defects from thermal stress.

A second prior art is known by the acronym SWAMI (Sidewall Masked Isolation Technology) and described, for example in an article "The SWAMI - a defect-free and near-zero bird's beak local oxidation process and its application in VLSI technology", IEDM Tech. Dig. 1982, pages 224-227. While being advantageous from several aspects, that technique is beset with problems of sidewall profile control and etching depth. In addition, damage may be caused to the silicon surface during the silicon island etching.

To overcome such problems, the FUROX (FUlly Recessed OXide) method has been proposed as described in "A new fully recessed-oxide field isolation technology for scaled VLSI Circuit fabrication", IEEE Electron Device Letters, vol. EDL-7, No. 2, February 1986, pages 124-126.

The last-mentioned process involves at least two separate oxidation steps, of which the first still results in the development of a bird's beak of significant size.

Other approch is disclosed for example in the IBM Technical Disclousure Bulletin , vol. 24 no. 9,concerning a "Method for forming recessed oxide isolation islands" where an important theaching is provided.

This document relates to the possibility of partially preventing the formation of "bird's beak" while growing oxide isolation regions in a semiconductor body by using small undercuts in an oxide layer filled with nitride.

This semiconductor body is formed by growing a first oxide layer on a semiconductor substrate and covering this first layer by a first nitride layer.

After a conventional photolitographic step defining a predeterminate area for growing the recessed oxide, a selective etching step is performed to create the undercuts.

A deposition of second nitride layer is required to fill the undercuts.

The thickness of the second nitride layer being slightly greater than half the thickness of the slide layer.

The semiconductor body is then subjected to a vertical reactive ion etching step to etch away portions of the second nitride layer with the exception of the undercuts.

Subsequently, a depression is formed in the seminconductor body by a coventional silicon etching where the recessed oxide can be grown.

The undercuts filled with nitride doesn't allow migration of oxygen, and hence formation of the bird's beak.

Another solution is disclosed in the European patent application No. EP-A-0 052 948 which relates to an oxide isolation process providing a peculiar teaching about controlling the oxidation phase in a seat formed in a semiconductor body by sidewalls partially protected with nitride and a double nitride layer overhanging the seat.

The solution hereby uses an anisotropic etch to define exactly which parts of sidewalls must be protected by nitride.

Nevertheless this is not easy to performe because if anisotropic etch is not well controlled can also destroy the overhanging layer which is of a primary importance to forbid the growing of bird's beak.

In the NL-A-8 601 415 patent application is being shown the possibility to forbid the growing of the bird's beak with a structure similar to that disclosed in the IBM Bullettin vol. 24 no. 9 in which undercuts are formed in the oxide layer and are filled with nitride.

The nitride layer used to fill the undercuts is removed by isotropic wet etching performed with ortophosforic acid.

In this application no care is set on the problem to obtain a planar structure so no kind of seat or depression is created in the area where the recessed oxide has to be grown.

The underlying technical problem of this invention is to provide a method for eliminating the so-called bird's beak from local oxidations, while overcoming the limitations of current approaches based on prior art techniques.

The solutive idea on which this invention stands is one of only avoiding that in the seat or in the trench seat where the oxide is to be grown a complete removing of the second nitride layer is obtained except from the recesses which remain occluded by nitride portion.

This allow to grow the oxide in the seat or in the trench seat avoiding stress into the active areas of the semiconductor device delimited by isolation regions or sidewall oxide regions.

Based on this solutive idea, the technical problem is solved by a method as indicated hereinabove and defined in Claim 1.

The features and advantages of the inventive method will become apparent from the following detailed description of some embodiments thereof, given by way of example and not of limitation with reference to the accompanying drawings.

In the drawings:
- Figures 1 to 3 are respective views showing schematically the production of a local oxidation on a semiconductor device;
- Figures 4 to 8 show schematically a exemplary application of the inventive method, specifically to nonplanar structures; and
- Figures 9 to 13 show schematically a second embodiment of the method according to the invention.

With reference to the drawing views, the steps of the method according to the invention are illustrated therein in schematic form through successive modifications to the morphology of a monolithic semiconductor device.

The device comprises a monocrystalline silicon substrate 1 over which a layer 2 of silicon thermal oxide has been grown. The oxide 2 is covered by a first layer 3 of silicon nitride.

Using conventional techniques, a pit 7 is opened through the layers 2 and 3 to the substrate 1. This pit 7 is intended to provide an isolation region, such as a field oxide region.

An example of the application of the method according to the invention will now be described.

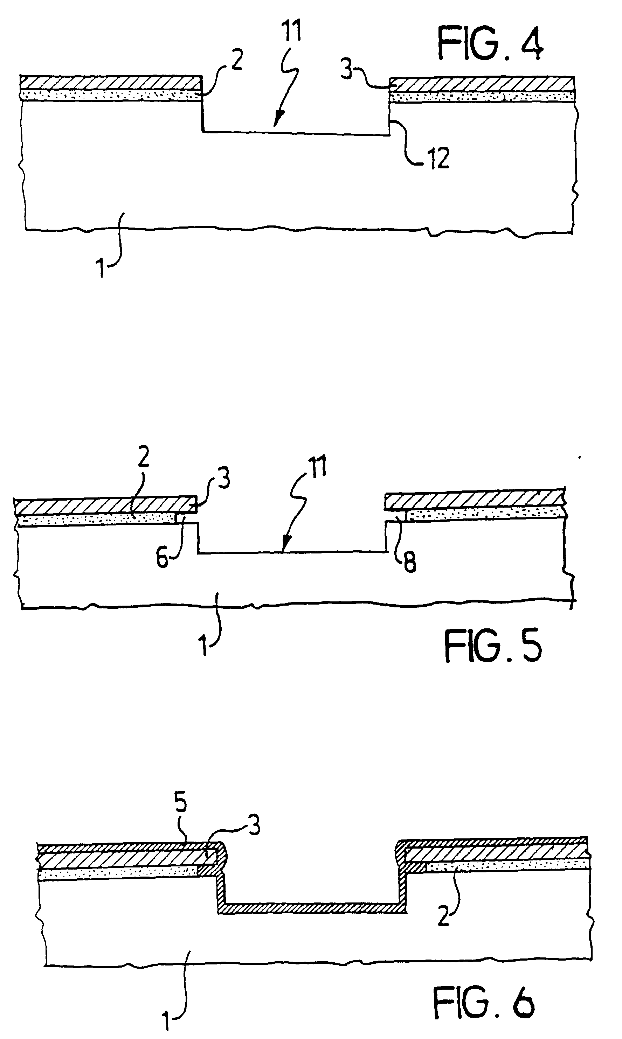

Shown in Figure 4 is a semiconductor device which comprises the substrate 1, layer 2 of thermal oxide and first upper layer 3 of nitride.

The device has been formed with an pit 11.

In fact, this pit 11 is also dug in the substrate 1 to define a seat 12 for receiving an isolation region 4 consisting of field oxide.

The inventive method provides, for selective wet etching, using diluted hydrofluoric acid. This etching only causes the thermal oxide 2 to be dug laterally of the pit 11, as shown in Figure 5.

The etching is only effective in the pit area unprotected by the nitride 3 and defines opposing recesses 6 and 8 at the pit 11 sides. The digging depth will depend on the etching duration.

The next step consists of depositing a second layer 5 of silicon nitride. This second layer of nitride has a thickness slightly greater than one half that of the thermal oxide layer 2.

The nitride of the layer 5 also penetrates the recesses 6 and 8, obstructing them.

A subsequent etching step, as by etching with orthophosphoric acid, enables the nitride layer 5 to be removed, except from the recesses 6 and 8 which will remain occluded by residues 9 and 10.

At this point, the field oxide 4 is grown in the seat 12.

The presence of nitride occlusions is effective to resist formation of the bird's beak while the field oxide 4 is grown.

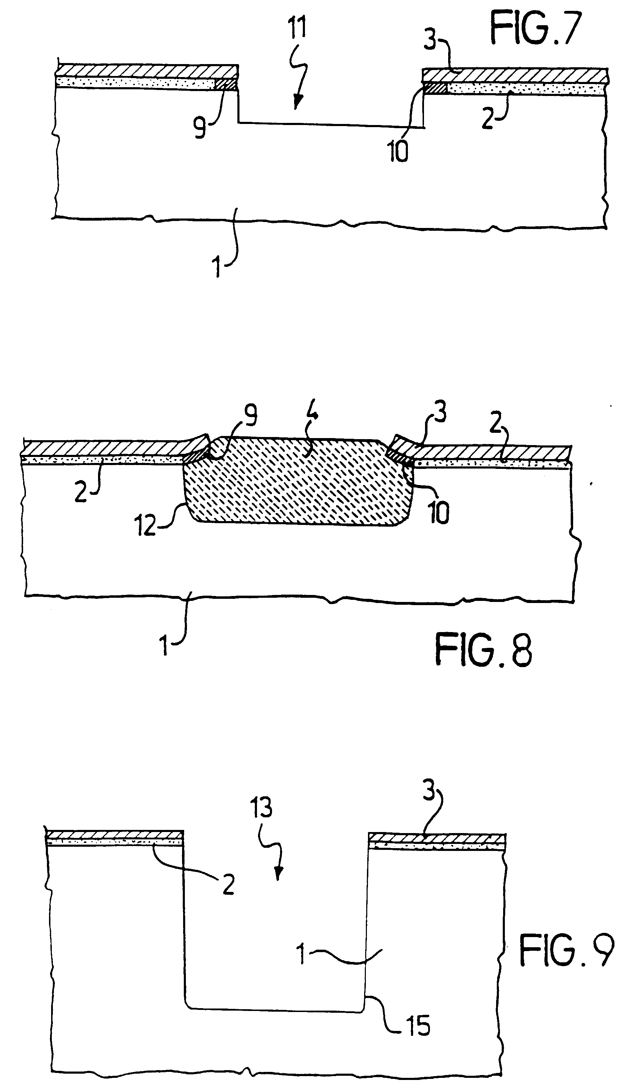

It has been observed experimentally, in fact, that the profile of the field oxide 4 grown in the seat 12 is free of the intrusive bird's beak, as can be appreciated from Figure 8.

Lastly, a second example of the application of the inventive method will be described.

This example relates specifically to a possible embodiment of the inventive method directed to allow the formation of sidewall oxide in a trench-type structure.

For this purpose, a semiconductor substrate 1 is provided as in the previous embodiments which is covered by a layer 2 of thermal oxide, in turn covered by a first layer 3 of nitride.

The semiconductor is formed with a deep pit 13, or so-called trench pit (Figure 9), defining a seat 15 whereinto the so-called sidewall oxide is received.

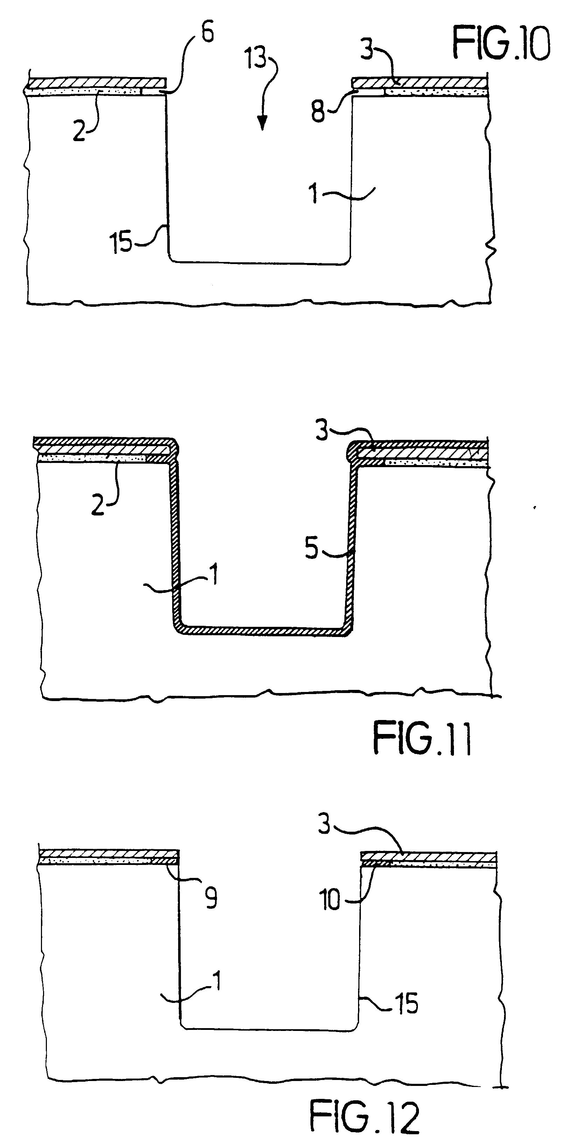

A first selective wet etching step, using diluted hydrofluoric acid, results in just the thermal oxide 2 being dug laterally of the pit 13, as shown in Figure 10.

The etching is only effective in the uncovered area, unprotected by the nitride 3, and defines oppositely located recesses 6 and 8 at the sides of the pit 13. The digging depth will depend on the duration of the etching applied.

The next step in the method consists of depositing a second layer 5 of silicon nitride. This, the second, layer of nitride slightly exceeds in thickness one half of the thermal oxide layer 2 thickness.

The layer 5 nitride is deposited isotropically across the side walls of the pit 13 and also penetrates the recesses 6 and 8, obstructing them.

Similarly as in the previous embodiments, a subsequent etching step enables the nitride layer 5 to be removed, excepting from the recesses 6 and 8 which remain occluded by residues 9 and 10. At this point, the sidewall oxide 14 is grown on the inner walls of the seat 15.

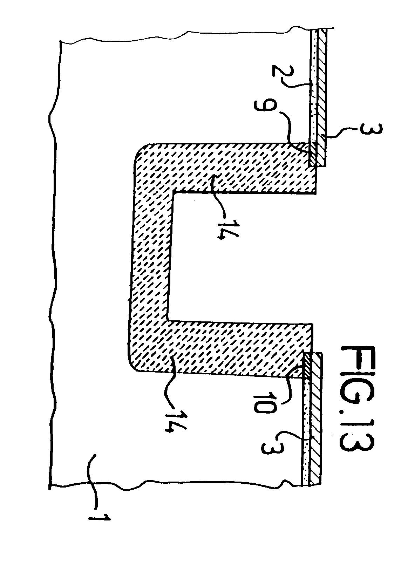

It can be appreciated from the example shown in Figure 13 that the resultant profile of the sidewall oxide 14 from the inventive method exhibits no bird's beak.

Understandably, the semiconductor structure may be completed with the addition of active areas within the region bounded by the sidewall oxide.

The major advantages afforded by the method of this invention include the possibility of enhancing the degree of integration of semiconductor electronic devices.

## Claims

1. A method for eliminating the bird's beak while forming recessed oxide regions by selective oxidation in a semiconductor body having a semiconductor substrate (1) which is covered by an oxide layer (2) and with a first nitride layer (3) formed on the oxide layer (2), comprising the following steps:
- opening a pit (11) or a trench pit (13) through the nitride layer (3) and the oxide layer (3) by a first etching step to define a recessed seat or trench (12, 13) in said semiconductor substrate (1) for growing an isolation region (4) including field oxide into said seat or a sidewall oxide (14) region into said trench (15),
- selectively wet etching the oxide layer (2) to remove it around the sides of said seat (12) or trench (13) between the substrate (1) and the first nitride layer (3) to define peripheral recesses (6,8) or undercuts between the substrate (1) and the first nitride layer (3);
- depositing a second nitride layer (5) extending into the interior of the seat (12) or the trench (13), occluding said undercuts (6, 8) with nitride, the thickness of the second nitride layer (5) being slightly greater than half the thickness of the oxide layer (2); and,
- subsequently etching said second nitride layer (5) to remove it with the exception of the undercuts (6, 8) which remains occluded by nitride portions (9, 10); and
- growing oxide in said seat (12) or trench (13) so as to form said isolation region (4) including field oxide containing or respective sidewall (14) oxide regions abutting said nitride portions (9,10) which occlude said recesses (6,8).

2. A method according to claim 1, characterized in that said subsequent etching step is performed by using orthophosphoric acid.

## Patentansprüche

1. Verfahren zum Eliminieren des "Vogelschnabels" bei der Bildung von vertieften Oxidbereichen durch selektive Oxidation in einem Halbleiterkörper, der ein Halbleitersubstrat (1) aufweist, das von einer Oxidschicht (2) und einer auf der Oxidschicht (2) ausgebildeten ersten Nitridschicht (3) bedeckt ist, wobei das Verfahren folgende Schritte aufweist:
- Öffnen einer Vertiefung (11) oder einer Graben-Vertiefung (13) durch die Nitridschicht (3) und die Oxidschicht (2) hindurch mittels eines ersten Ätzschrittes zum Bilden einer vertieften Aufnahme oder eines Grabens (12, 13) in dem Halbleitersubstrat (1) zum Aufwachsen eines Isolierbereichs (4), der Feldoxid beinhaltet, in der Aufnahme oder zum Aufwachsen eines Seitenwandoxidbereichs (14) in dem Graben (15),
- selektives Naßätzen der Oxidschicht (2) zum Entfernen derselben um die Seiten der Aufnahme (12) oder des Grabens (13) zwischen dem Substrat (1) und der ersten Nitridschicht (3) um dadurch periphere Vertiefungen (6, 8) oder Hinterschneidungen zwischen dem Substrat (1) und der ersten Nitridschicht (3) zu bilden;
- Aufbringen einer zweiten Nitridschicht (5), die sich in das Innere der Aufnahme (12) oder des Grabens (13) hineinerstreckt und die Hinterschneidungen (6, 8) mit Nitrid verschließt, wobei die Dicke der zweiten Nitridschicht (5) geringfügig größer ist als die Hälfte der Dicke der Oxidschicht (2); und
- anschließendes Ätzen der zweiten Nitridschicht (5) zum Entfernen derselben mit Ausnahme der Hinterschneidungen (6, 8), die durch Nitridbereiche (9, 10) verschlossen bleiben; und
- Aufwachsen von Oxid in der Aufnahme (12) oder dem Graben (13) zur Bildung des Isolierbereichs (4), der eine Feldoxidkontaktierung beinhaltet, oder von jeweiligen Seitenwandoxidbereichen (14) in Anlage an den Nitridbereichen (9, 10), die die Vertiefungen (6, 8) verschließen.

2. Verfahren nach Anspruch 1,
**dadurch gekennzeichnet,**
daß der anschließende Ätzschritt unter Verwendung von Orthophosphorsäure durchgeführt wird.

## Revendications

1. Un procédé pour éliminer le "bird's beak" lors de la formation de régions en creux d'oxyde par oxydation sélective dans un corps semi-conducteur comportant un substrat semi-conducteur (1) qui est revêtu d'une couche d'oxyde (2), et avec une première couche de nitrure (3) formée sur la couche d'oxyde (2), comprenant les étapes suivantes :
- ouvrir une cavité (11) ou une saignée (13) à travers la couche de nitrure (3) et la couche d'oxyde (2) lors d'une première étape de gravure, pour définir un siège en creux ou saignée (12, 13) dans ledit substrat semi-conducteur (1) en vue de faire croître une région d'isolation (4) comprenant de l'oxyde de champ dans ledit siège, ou une région d' oxyde de paroi (14) dans ladite saignée (15),
- sélectivement graver par voie humide la couche d'oxyde (2) pour la retirer autour des côtés dudit siège (12) ou de la saignée (13) entre le substrat (1) et la première couche de nitrure (3) pour définir des creux périphériques ou sillons (6, 8) entre le substrat (1) et la première couche de nitrure (3) ;
- déposer une seconde couche de nitrure (5) s'étendant dans l'intérieur du siège (12) ou de la saignée (13), en obstruant lesdits sillons (6, 8) avec du nitrure, l'épaisseur de la seconde couche de nitrure étant légèrement supérieure à la moitié de l'épaisseur de la couche d'oxyde (2) ; et,
- procéder à une gravure ultérieure de ladite seconde couche de nitrure (5) pour la retirer, à l'exception des sillons (6, 8) qui restent obstrués par des portions de nitrure (9, 10) ; et
- faire croître de l'oxyde dans ledit siège (12) ou ladite saignée (13) afin de former ladite région d'isolation (4) comprenant de l'oxyde de champ en contact avec lesdites parties de nitrure (9, 10) qui obstruent lesdits creux (6, 8), ou des régions d'oxyde de paroi respectives (14) venant au contact desdites parties de nitrure (9, 10).

2. Un procédé selon la revendication 1, caractérisé en ce que ladite étape de gravure ultérieure est réalisée en utilisant de l'acide orthophosphorique.
